# EUROPÄISCHE PATENTANMELDUNG

(11) **EP 2 154 167 A1**
(43) Veröffentlichungstag der Anmeldung: **17.02.2010**
(21) Anmeldenummer: 08013648.4
(22) Anmeldetag: 30.07.2008
(51) Int. Cl.: C08G 18/10, C08G 18/32, C09D 175/02

(54) **Elektromechanischer Wandler mit einem Polymerelement auf Polyisocyanat-Basis**

(71) Anmelder: Bayer MaterialScience AG, 51368 Leverkusen (DE)
(72) Erfinder: Jenninger, Werner, Dr., 50674 Köln (DE); Dörr, Sebastian, Dr., 40597 Düsseldorf (DE); Wagner, Joachim, Dr., 51061 Köln (DE); Köhler, Burkhardt, Dr., 34289 Zierenberg (DE); Heckroth, Heike, Dr., 51519 Odenthal (DE); Matner, Mathias, Dr., 41464 Neuss (DE)

(57) **Zusammenfassung**

Die vorliegende Erfindung betrifft einen elektromechanischen Wandler, insbesondere einen elektromechanischen Sensor, Aktuator und/oder Generator, der ein Polymerelement aufweist, welches aus einer Reaktionsmischung, umfassend ein Polyisocyanat oder ein PolyisocyanatPrepolymer oder eine Mischung davon und eine Verbindung mit mindestens zwei isocyanatreaktiven Aminogruppen, erhältlich ist. Darüber hinaus betrifft die vorliegende Erfindung ein Verfahren zur Herstellung eines derartigen elektromechanischen Wandlers sowie die Verwendung eines derartigen Polymerelements als elektromechanisches Element. Ferner betrifft die vorliegende Erfindung eine elektronische und/oder elektrische Vorrichtung, welche einen erfindungsgemäßen elektromechanischen Wandler umfasst sowie die Verwendung eines erfindungsgemäßen elektromechanischen Wandlers in einer elektronischen und/oder elektrischen Vorrichtung.

## Beschreibung

Die vorliegende Erfindung betrifft einen elektromechanischen Wandler, insbesondere einen elektromechanischen Sensor, Aktuator und/oder Generator, der ein Polymerelement aufweist, welches aus einer Reaktionsmischung, umfassend ein Polyisocyanat oder ein Polyisocyanat-Prepolymer oder eine Mischung davon und eine Verbindung mit mindestens zwei isocyanatreaktiven Aminogruppen, erhältlich ist. Darüber hinaus betrifft die vorliegende Erfindung ein Verfahren zur Herstellung eines derartigen elektromechanischen Wandlers sowie die Verwendung eines derartigen Polymerelements als Aktuator, Sensor und/oder Generator. Ferner betrifft die vorliegende Erfindung eine elektronische und/oder elektrische Vorrichtung, welche einen erfindungsgemäßen elektromechanischen Wandler umfasst, sowie die Verwendung eines erfindungsgemäßen elektromechanischen Wandlers in einer elektronischen und/oder elektrischen Vorrichtung.

Ein elektromechanischer Wandler wandelt elektrische Energie in mechanische Energie um und umgekehrt. Elektromagnetische Wandler können daher als Sensoren, Aktuatoren und/oder Generatoren eingesetzt werden.

Der grundsätzliche Aufbau eines solchen Wandlers basiert auf einer Schicht aus einem elektroaktiven Polymer, welche beidseitig mit Elektroden beschichtet ist. Dabei wird unter einem elektroaktiven Polymer ein Polymer verstanden, welches sein Volumen und/oder seine Form in Abhängigkeit von einer daran anliegenden Spannung ändert und/oder welches durch eine Volumen- und/oder Formänderung eine Spannung erzeugen kann.

Die WO 01/06575 A1 offenbart, dass diese Eigenschaften beispielsweise Silikonelastomere, Acrylelastomere, Polyurethane, thermoplastische Elastomere, Polytetrafluorethylen umfassende Copolymere, Fluorelastomere und Silikon- und Acryl-Gruppen umfassende Polymere aufweisen können.

Ferner ist aus der EP 1 081 171 A2 und DE-A 102 46 708 A1 bekannt, dass Polyurethan-Prepolymere durch Asparaginsäureester vernetzt werden können.

Herkömmliche in elektromechanischen Wandlern eingesetzte Polymere weisen jedoch häufig schlechte mechanische und andere Eigenschaften, insbesondere nachteilige Dehnungseigenschaften, eine geringe Isolationswirkung, insbesondere niedrige Durchbuchsfeldstärken und hohe elektrische Leitfähigkeiten, eine schlechte Prozessierbarkeit und hohe Materialkosten auf. Insbesondere kann durch herkömmlicherweise in elektromechanischen Wandlern eingesetzte Polymere, beispielsweise Silikone, eine Kombination der gewünschten Eigenschaftsmerkmale nicht in einem Material erzielt werden.

Aufgabe der vorliegenden Erfindung war es daher, einen elektromechanischen Wandler zur Verfügung zu stellen, der die Nachteile bekannter elektromechanischer Wandler überwindet.

Im Rahmen der vorliegenden Erfindung wurde gefunden, dass diese Aufgabe durch ein Polymerelement, welches aus einer Reaktionsmischung umfassend ein Polyisocyanat oder ein Polyisocyanat-Prepolymer oder eine Mischung davon und eine Verbindung mit mindestens zwei isocyanatreaktiven Aminogruppen, insbesondere einem aminofunktionellen Asparaginsäureester, erhältlich ist, gelöst wird. Dabei werden im Rahmen der vorliegenden Erfindung unter einem "Polyisocyanat" beziehungsweise "Polyisocyanat-Prepolymer" Verbindung verstanden, die mindestens zwei freie Isocyanat-Gruppen aufweisen. Mit anderen Worten, unter einem "Polyisocyanat" beziehungsweise "Polyisocyanat-Prepolymer" werden Verbindung verstanden, die mindestens zweifach isocyanat-funktionell sind.

Gegenstand der vorliegenden Erfindung ist daher ein elektromechanischer Wandler, der mindestens zwei Elektroden und mindestens ein Polymerelement aufweist, wobei das Polymerelement zwischen zwei Elektroden angeordnet ist und insbesondere mindestens eine der Elektroden kontaktiert, und wobei das Polymerelement erfindungsgemäß aus einer, beispielsweise filmbildenden, Reaktionsmischung umfassend die folgenden Komponenten
A) ein Polyisocyanat oder ein Polyisocyanat-Prepolymer oder eine Mischung davon, und
B) eine Verbindung mit mindestens zwei isocyanatreaktiven Aminogruppen,
erhältlich ist.

Dabei werden im Rahmen der vorliegenden Erfindung die Begriffe "ein" und "eine" im Zusammenhang mit den Komponenten A) und B) nicht als Zahlwörter, sondern als unbestimmter Artikel verwendet.

Wenn eine mechanische Beanspruchung auf einen derartigen Wandler ausgeübt wird, so deformiert sich der Wandler beispielsweise entlang seiner Dicke und ein starkes elektrisches Signal kann an den Elektroden detektiert werden. Damit wird mechanische Energie in elektrische Energie umgewandelt. Der erfindungsgemäße Wandler kann folglich sowohl als Generator als auch als Sensor eingesetzt werden.

Unter Ausnutzung des entgegengesetzten Effekts, nämlich der Umwandlung von elektrischer Energie in mechanische Energie, kann der erfindungsgemäße Wandler andererseits gleichermaßen als Aktuator dienen.

Im Rahmen einer Ausführungsform der vorliegenden Erfindung ist das Polymerelement derart zwischen zwei Elektroden angeordnet, dass diese auf gegenüberliegenden Seiten des Polymerelements an dieses angrenzen. Beispielsweise kann das Polymerelement beidseitig mit Elektroden beschichtet sein.

Ein weiterer Gegenstand der vorliegenden Erfindung ist ein Verfahren zur Herstellung eines erfindungsgemäßen elektromechanischen Wandlers, in dem
- mindestens zwei Elektroden bereitgestellt werden, und
- ein Polymerelement durch Umsetzung einer Reaktionsmischung umfassend die folgenden Komponenten
   A) ein Polyisocyanat oder ein Polyisocyanat-Prepolymer oder eine Mischung davon, und
   B) eine Verbindung mit mindestens zwei isocyanatreaktiven Aminogruppen,
   bereitgestellt wird, und
- das Polymerelement zwischen zwei Elektroden angeordnet wird.

Insbesondere kann das Polymerelement dabei derart zwischen zwei Elektroden angeordnet werden, dass das Polymerelement mindestens eine der Elektroden kontaktiert.

Im Rahmen einer bevorzugten Ausführungsform des erfindungsgemäßen Verfahrens wird das Polymerelement durch Auftragen der Reaktionsmischung auf mindestens eine der Elektroden bereitgestellt. Dies kann beispielsweise durch Rakeln, Streichen, Gießen, Schleudern, Sprühen oder Extrusion erfolgen. Es ist im Rahmen der vorliegenden Erfindung jedoch ebenso möglich, die Elektroden und das Polymerelement in separaten Schritten herzustellen und nachträglich zusammen zu fügen.

Im Rahmen einer bevorzugten Ausführungsform des erfindungsgemäßen Verfahrens wird die Reaktionsmischung getrocknet und/oder getempert. Das Trocknen kann dabei in einem Temperaturbereich von ≥ 0 °C bis ≤ 200 °C, beispielsweise für ≥ 0,1 min bis ≤ 48 h, insbesondere für ≥ 6 h bis ≤ 18 h erfolgen. Das Tempern kann beispielsweise in einem Temperaturbereich von ≥ 80 °C bis ≤ 250 °C, beispielsweise für ≥ 0,1 min bis ≤ 24 h, erfolgen.

Ein weiterer Gegenstand der vorliegenden Erfindung ist die Verwendung eines Polymerelements, erhältlich aus einer Reaktionsmischung umfassend die folgenden Komponenten
A) ein Polyisocyanat oder ein Polyisocyanat-Prepolymer oder eine Mischung davon, und
B) eine Verbindung mit mindestens zwei isocyanatreaktiven Aminogruppen,
als elektromechanisches Element, beispielsweise als Sensor, Aktuator und/oder Generator, insbesondere als elektromechanisches Element in einem Sensor, Aktuator und/oder Generator.

Eine weiterer Gegenstand der vorliegenden Erfindung ist eine elektronische und/oder elektrische Vorrichtung, insbesondere ein Baustein, Automat, Instrument oder eine Komponente, umfassend einen erfindungsgemäßen elektromechanischen Wandler.

Ferner betrifft die vorliegende Erfindung die Verwendung eines erfindungsgemäßen elektromechanischen Wandlers in einer elektronischen und/oder elektrischen Vorrichtung, insbesondere in einem Baustein, Automat, Instrument oder in einer Komponente.

Im Rahmen der vorliegenden Erfindung kann es sich bei dem Polymerelement um eine Polymerschicht, insbesondere einen Polymerfilm, eine Polymerfolie oder eine Polymerbeschichtung handeln. Beispielsweise kann die Polymerschicht eine Schichtdicke von ≥ 0,1 µm bis ≤ 1500 µm, beispielsweise von ≥ 1 µm bis ≤ 500 µm, insbesondere von ≥ 5 µm bis ≤ 200 µm, vorzugsweise von ≥ 5 µm bis ≤ 100 µm, aufweisen.

### Komponente A)

Im Rahmen der vorliegenden Erfindung kann Komponente A) grundsätzlich ein Polyisocyanat oder ein Polyisocyanat-Prepolymer oder eine Mischung davon sein. Beispielsweise kann Komponente A) ein Isocyanuratgruppen- und/oder Urethangruppen-haltiges Polyisocyanat oder ein Isocyanuratgruppen- und/oder Urethangruppen-haltiges Polyisocyanat-Prepolymer oder eine Mischung davon sein.

Als Polyisocyanat A) eignen sich beispielsweise 1,4-Butylendiisocyanat, 1,6 Hexamethylendiisocyanat (HDI), Isophorondiisocyanat (IPDI), 2,2,4 und/oder 2,4,4-Trimethylhexamethylendüsocyanat, die isomeren Bis-(4,4'-isocyanatocyclohexyl)methane oder deren Mischungen beliebigen Isomerengehalts, 1,4-Cyclohexylendiisocyanat, 4-Isocyanatomethyl-1,8-octandiisocyanat (Nonantriisocyanat), 1,4-Phenylendiisocyanat, 2,4- und/oder 2,6-Toluylendiisocyanat, 1,5-Naphthylendiisocyanat, 2,2'- und/oder 2,4'- und/oder 4,4'-Diphenylmethandiisocyanat, 1,3- und/oder 1,4-Bis-(2-isocyanato-prop-2-yl)-benzol (TMXDI), 1,3-Bis(isocyanatomethyl)benzol (XDI), Alkyl-2,6-diisocyanatohexanoate (Lysindiisocyanate) mit Alkylgruppen mit 1 bis 8 Kohlenstoffatomen sowie Mischungen davon.

Neben den vorstehend genannten Polyisocyanaten können auch modifizierte Diisocyanate, die eine Funktionalität ≥ 2 aufweisen, mit Uretdion-, Isocyanurat-, Urethan-, Allophanat, Biuret-, Iminooxadiazindion- oder Oxadiazintrionstruktur sowie Mischungen aus diesen anteilig eingesetzt werden.

Bevorzugt handelt es sich um Polyisocyanate oder Polyisocyanatgemische der vorstehend genannten Art mit ausschließlich aliphatisch oder cycloaliphatisch gebundenen Isocyanatgruppen oder Mischungen aus diesen und einer mittleren NCO-Funktionalität der Mischung von ≥ 2 bis ≤ 4, bevorzugt ≥ 2 bis ≤ 2,6 und besonders bevorzugt ≥ 2 bis ≤ 2,4.

Besonders bevorzugt werden als Komponente A) Polyisocyanate auf der Basis von Hexamethylendiisocyanat, Isophorondiisocyanat oder die isomeren Bis-(4,4'-isocyanatocyclohexyl)methane sowie Mischungen der vorgenannten Diisocyanate eingesetzt.

Die als Komponente A) ebenfalls einsetzbaren Polyisocyanat-Prepolymere können durch Umsetzung von Polyisocyanaten mit hydroxyfunktionellen, insbesondere polymeren, Polyolen gegebenenfalls unter Zusatz von Katalysatoren sowie Hilfs- und Zusatzstoffen erhalten werden.

Hydroxyfunktionelle, polymere Polyole können beispielsweise Polyesterpolyole, Polyacrylatpolyole, Polyurethanpolyole, Polycarbonatpolyole, Polyetherpolyole, Polyesterpolyacrylatpolyole, Polyurethanpolyacrylatpolyole, Polyurethanpolyesterpolyole, Polyurethanpolyetherpolyole, Polyurethanpolycarbonatpolyole und/oder Polyesterpolycarbonatpolyole sein. Diese können zur Herstellung des Polyisocyanat-Prepolymers einzeln oder in beliebigen Mischungen untereinander eingesetzt werden.

Zur Herstellung der Polyisocyanat-Prepolymere können Polyisocyanate, vorzugsweise Diisocyanate, mit Polyolen bei einem NCO/OH-Verhältnis im Allgemeinen von ≥ 4:1 bis ≤ 20:1, beispielsweise von 8:1, umgesetzt werden. Ein Anteil an nicht umgesetzten Polyisocyanaten kann anschließend abgetrennt werden. Hierfür kann die Dünnschichtdestillation verwendet, wobei restmonomerenarme Produkte mit Restmonomergehalten von beispielsweise ≤ 1 Gewichtsprozent, bevorzugt ≤ 0,5 Gewichtsprozent, besonders bevorzugt ≤ 0,1 Gewichtsprozent, erhalten werden. Die Reaktionstemperatur kann dabei ≥ 20 °C bis ≤ 120 °C, bevorzugt ≥ 60 °C bis ≤ 100 °C, betragen. Gegebenenfalls können während der Herstellung Stabilisatoren wie Benzoylchlorid, Isophthaloylchlorid, Dibutylphosphat, 3-Chlorpropionsäure oder Methyltosylat zugesetzt werden.

Geeignete Polyesterpolyole zur Herstellung der Polyisocyanat-Prepolymere können Polykondensate aus Di- sowie gegebenenfalls Tri- und Tetraolen und Di- sowie gegebenenfalls Tri- und Tetracarbonsäuren oder Hydroxycarbonsäuren oder Lactonen sein. Anstelle der freien Polycarbonsäuren können auch die entsprechenden Polycarbonsäureanhydride oder entsprechende Polycarbonsäureester von niederen Alkoholen zur Herstellung der Polyester verwendet werden.

Beispiele für geeignete Diole sind dabei Ethylenglykol, Butylenglykol, Diethylenglykol, Triethylenglykol, Polyalkylenglykole wie Polyethylenglykol, weiterhin 1,2-Propandiol, 1,3-Propandiol, Butandiol(1,3), Butandiol(1,4), Hexandiol(1,6) und Isomere, Neopentylglykol oder Hydroxypivalinsäureneopentylglykolester oder Mischungen davon, wobei Hexandiol(1,6) und Isomere, Butandiol(1,4), Neopentylglykol und Hydroxypivalinsäureneopentylglykolester bevorzugt sind. Daneben können auch Polyole wie Trimethylolpropan, Glycerin, Erythrit, Pentaerythrit, Trimetylolbenzol oder Trishydroxyethylisocyanurat oder Mischungen davon eingesetzt werden.

Als Dicarbonsäuren können dabei Phthalsäure, Isophthalsäure, Terephthalsäure, Tetrahydrophthalsäure, Hexahydrophthalsäure, Cyclohexandicarbonsäure, Adipinsäure, Azelainsäure, Sebacinsäure, Glutarsäure, Tetrachlorphthalsäure, Maleinsäure, Fumarsäure, Itaconsäure, Malonsäure, Korksäure, 2-Methylbernsteinsäure, 3,3-Diethylglutarsäure und/oder 2,2-Dimethylbemsteinsäure eingesetzt werden. Als Säurequelle können auch die entsprechenden Anhydride verwendet werden.

Sofern die mittlere Funktionalität des zu veresternden Polyols ≥ 2 ist, können zusätzlich auch Monocarbonsäuren, wie Benzoesäure und Hexancarbonsäure mit verwendet werden.

Bevorzugte Säuren sind aliphatische oder aromatische Säuren der vorstehend genannten Art. Besonders bevorzugt sind dabei Adipinsäure, Isophthalsäure und Phthalsäure.

Hydroxycarbonsäuren, die als Reaktionsteilnehmer bei der Herstellung eines Polyesterpolyols mit endständigen Hydroxylgruppen mitverwendet werden können, sind beispielsweise Hydroxycapronsäure, Hydroxybuttersäure, Hydroxydecansäure oder Hydroxystearinsäure oder Mischungen davon. Geeignete Lactone sind Caprolacton, Butyrolacton oder Homologe oder Mischungen davon. Bevorzugt ist dabei Caprolacton.

Ebenfalls können zur Herstellung der Polyisocyanat-Prepolymere A) hydroxylgruppenaufweisende Polycarbonate, beispielsweise Polycarbonatpolyole, bevorzugt Polycarbonatdiole, eingesetzt werden. Beispielsweise können diese ein zahlenmittleres Molekulargewichten Mₙ von ≥ 400 g/mol bis ≤ 8000 g/mol, bevorzugt ≥ 600 g/mol bis ≤ 3000 g/mol eingesetzt werden. Diese können durch Reaktion von Kohlensäurederivaten, wie Diphenylcarbonat, Dimethylcarbonat oder Phosgen, mit Polyolen, bevorzugt Diolen, erhalten werden.

Beispiele hierfür geeigneter Diole sind Ethylenglykol, 1,2- und 1,3-Propandiol, 1,3- und 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A oder lactonmodifizierte Diole der vorstehend genannten Art oder Mischungen davon.

Bevorzugt enthält die Diolkomponente dabei ≥ 40 Gewichtsprozent bis ≤ 100 Gewichtsprozent Hexandiol, vorzugsweise 1,6-Hexandiol und/oder Hexandiolderivate. Solche Hexandiolderivate basieren auf Hexandiol und können neben endständigen OH-Gruppen Ester- oder Ethergruppen aufweisen. Derartige Derivate sind beispielsweise durch Reaktion von Hexandiol mit überschüssigem Caprolacton oder durch Veretherung von Hexandiol mit sich selbst zum Di- oder Trihexylenglykol erhältlich. Die Menge dieser und anderer Komponenten, werden im Rahmen der vorliegenden Erfindung in bekannter Weise derart gewählt, dass die Summe 100 Gewichtsprozent nicht überschreitet, insbesondere 100 Gewichtsprozent ergibt.

Hydroxylgruppen aufweisende Polycarbonate, insbesondere Polycarbonatpolyole, sind bevorzugt linear gebaut.

Ebenfalls können zur Herstellung der Polyisocyanat-Prepolymere A) Polyetherpolyole eingesetzt werden. Beispielsweise eignen sich Polytetramethylenglykolpolyether wie sie durch Polymerisation von Tetrahydrofuran mittels kationischer Ringöffnung erhältlich sind. Ebenfalls geeignete Polyetherpolyole können die Additionsprodukte von Styroloxid, Ethylenoxid, Propylenoxid, Butylenoxid und/oder Epichlorhydrin an di- oder polyfunktionelle Startermoleküle sein. Als geeignete Startermoleküle können beispielsweise Wasser, Butyldiglykol, Glycerin, Diethylenglykol, Trimethyolpropan, Propylenglykol, Sorbit, Ethylendiamin, Triethanolamin, oder 1,4-Butandiol oder Mischungen davon eingesetzt werden.

Bevorzugte Komponenten zur Herstellung der Polyisocyanat-Prepolymere sind Polypropylenglykol, Polytetramethylenglykolpolyether und Polycarbonatpolyole beziehungsweise deren Mischungen, wobei Polypropylenglykol besonders bevorzugt ist.

Dabei können polymere Polyole mit einem zahlenmittleren Molekulargewicht Mₙ von ≥ 400 g/mol bis ≤ 8000 g/mol, bevorzugt von ≥ 400 g/mol bis ≤ 6000 g/mol und besonders bevorzugt von ≥ 600 g/mol bis ≤ 3000 g/mol eingesetzt werden. Diese weisen bevorzugt eine OH-Funktionalität von ≥ 1,5 bis ≤ 6, besonders bevorzugt von ≥ 1,8 bis ≤ 3, ganz besonders bevorzugt von ≥ 1,9 bis ≤ 2,1 auf.

Neben den genannten polymeren Polyolen können auch kurzkettige Polyole bei der Herstellung der Polyisocyanat-Prepolymere A) eingesetzt werden. Beispielsweise kann Ethylenglykol, Diethylenglykol, Triethylenglykol, 1,2-Propandiol, 1,3-Propandiol, 1,4-Butandiol, 1,3-Butylenglykol, Cyclohexandiol, 1,4-Cyclohexandimethanol, 1,6-Hexandiol, Neopentylglykol, Hydrochinondihydroxyethylether, Bisphenol A (2,2-Bis(4-hydroxyphenyl)propan), hydriertes Bisphenol A (2,2-Bis(4-hydroxycyclohexyl)propan), Trimethylolpropan, Trimethylolethan, Glycerin oder Pentaerythrit oder eine Mischung davon eingesetzt werden.

Geeignet sind auch Esterdiole des genannten Molekulargewichtsbereichs wie α-Hydroxybutyl-εhydroxy-capronsäureester, ω-Hydroxyhexyl-γ-hydroxybuttersäure-ester, Adipinsäure-(β-hydroxyethyl)ester oder Terephthalsäurebis(β-hydroxyethyl)-ester.

Ferner können zur Herstellung der Polyisocyanat-Prepolymere auch monofunktionelle isocyanatreaktive Hydroxylgruppenhaltige Verbindungen eingesetzt werden. Beispiele solcher monofunktionellen Verbindungen sind Ethanol, n-Butanol, Ethylenglykolmonobutylether, Diethylenglykolmonomethylether, Diethylenglykolmonobutylether, Propylenglykolmonomethylether, Dipropylenglykol-monomethylether, Tripropylenglykolmonomethylether, Dipropylenglykolmono-propylether, Propylenglykolmonobutylether, Dipropylenglykolmonobutylether, Tripropylenglykolmonobutylether, 2-Ethylhexanol, 1-Octanol, 1-Dodecanol oder 1-Hexadecanol oder Mischungen davon.

Weiterhin können NH₂- und/oder NH-funktionelle Komponenten zur Herstellung der Polyisocyanat-Prepolymere A) eingesetzt werden.

Geeignete Komponenten zur Kettenverlängerung sind organische Di- oder Polyamine. Beispielsweise eignen sich Ethylendiamin, 1,2- Diaminopropan, 1,3-Diaminopropan, 1,4-Diaminobutan, 1,6-Diaminohexan, Isophorondiamin, Isomerengemisch von 2,2,4- und 2,4,4-Trimethylhexa- methylendiamin, 2-Methylpentamethylendiamin, Diethylentriamin, Diaminodicyclohexylmethan oder Dimethylethylendiamin oder Mischungen davon.

Darüber hinaus können auch Verbindungen, die neben einer primären Aminogruppe auch sekundäre Aminogruppen oder neben einer Aminogruppe (primär oder sekundär) auch OH-Gruppen aufweisen, zur Herstellung der Polyisocyanat-Prepolymere A) eingesetzt werden. Beispiele hierfür sind primäre/sekundäre Amine, wie Diethanolamin, 3-Amino-1-methylaminopropan, 3-Amino-1-ethylaminopropan, 3-Amino-1-cyclohexylaminopropan, 3-Amino-1-methylaminobutan, Alkanolamine wie N-Aminoethylethanolamin, Ethanolamin, 3-Aminopropanol, Neopentanolamin. Zur Kettenterminierung werden üblicherweise Amine mit einer gegenüber Isocyanaten reaktiven Gruppe wie Methylamin, Ethylamin, Propylamin, Butylamin, Octylamin, Laurylamin, Stearylamin, Isononyloxypropylamin, Dimethylamin, Diethylamin, Dipropylamin, Dibutylamin, N-Methylaminopropylamin, Diethyl(methyl)aminopropylamin, Morpholin, Piperidin, beziehungsweise geeignete substituierte Derivate davon, Amidamine aus diprimären Aminen und Monocarbonsäuren, Monoketim von diprimären Ammen, primär/tertiäre Amine, wie N,N-Dimethylaminopropylamin, verwendet.

Die in A) eingesetzten Isocyanate, Polyisocyanate, Polyisocyanat-Prepolymere oder Isocyanatmischungen haben bevorzugt eine mittlere NCO-Funktionalität von ≥ 1,8 bis ≤ 5, besonders bevorzugt ≥ 2 bis ≤ 3,5 und ganz besonders bevorzugt ≥ 2 bis ≤ 2,5.

### Komponente B)

Im Rahmen der vorliegenden Erfindung kann Komponente B) grundsätzlich eine Verbindung mit mindestens zwei isocyanatreaktiven Aminogruppen sein. Beispielsweise kann Komponente B) ein Polyamin mit mindestens zwei isocyanatreaktiven Aminogruppen sein. Dabei wird im Rahmen der vorliegenden Erfindung unter einer isocyanatreaktiven Aminogruppe eine NH₂- oder NH-Gruppe verstanden.

Bevorzugt ist oder umfasst Komponente B) einen aminofunktionellen Asparaginsäureester, insbesondere einen aminofunktionellen Polyasparaginsäureester.

Die Herstellung der bevorzugt eingesetzten aminofunktionellen Asparaginsäureester B) kann durch Umsetzung der entsprechenden primären mindestens difunktionellen Amine X(NH₂)ₙ mit Malein- oder Fumarsäureestern der allgemeinen Formel:

R₁OOC-CH=CH-COOR₂

erfolgen. Bevorzugte Malein- oder Fumarsäureester sind Maleinsäuredimethylester, Maleinsäurediethylester, Maleinsäuredibutylester und die entsprechenden Fumarsäureester. Bevorzugte primäre mindestens difunktionelle Amine X(NH₂)ₙ sind Ethylendiamin, 1,2-Diaminopropan, 1,4-Diaminobutan, 1,6-Diaminohexan, 2,5-Diamino-2,5-dimethylhexan, 2-Methyl-1.5-Diaminopentan, 2,2,4- und/oder 2,4,4Trimethyl-1,6-diaminohexan, 1,11-Diaminoundecan, 1,12-Diaminododecan, 1Amino-3,3,5-trimethyl-5-aminomethylcyclohexan, 2,4- und/oder 2,6-Hexahydrotoluylendiamin, 2,4'- und/oder 4,4'-Diaminodicyclohexylmethan, 3,3'-Dimethyl-4,4'-diaminodicyclohexyl-methan, 2,4,4'-Triamino-5-methyl-dicyclohexylmethan und Polyetheramine mit aliphatisch gebundenen primären Aminogruppen mit einem zahlenmittleren Molekulargewicht Mₙ von ≥ 148 g/mol bis ≤ 6000 g/mol oder Mischungen davon. Besonders bevorzugte primäre mindestens difunktionelle Amine sind 4-Diaminobutan, 1,6-Diaminohexan, 2-Methyl-1.5-Diaminopentan, 2,2,4-Trimethyl-1,6-diaminohexan oder 2,4,4-Trimethyl-1,6-diaminohexan oder Mischungen davon.

Im Rahmen einer bevorzugten Ausführungsform der vorliegenden Erfindung ist oder umfasst Komponente B) einen aminofunktioneller Asparaginsäureester der allgemeinen Formel (I): 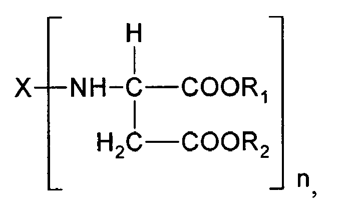 wobei
- X: für einen n-wertigen organischen Rest steht, der durch Entfernung von mindestens zwei primären Aminogruppen eines n-wertigen Amins erhalten wird,
- R1, R2: für gleiche oder unterschiedliche organische Reste stehen, die keinen Zerewitinoff-aktiven Wasserstoff aufweisen, und
- n: für eine ganze Zahl ≥ 2 steht.

Vorzugsweise steht X in Formel (I) für einen zwei-wertigen organischen Rest, der durch Entfernung der Aminogruppen von 1,4-Diaminobutan, 1,6-Diaminohexan, 2-Methyl-1.5-Diaminopentan, 2,2,4- oder 2,4,4-Trimethyl-1,6-diaminohexan erhalten wird.

Unter dem Begriff "Zerewitinoff-aktiver Wasserstoff' wird dabei im Rahmen der vorliegenden Erfindung gebundener Wasserstoff verstanden, der nach einem von Zerewitinoff aufgefundenen Verfahren durch Umsetzung mit Methylmagnesiumjodid Methan liefert. Insbesondere werden im Rahmen der vorliegenden Erfindung OH-, NH- und SH-Gruppen als Gruppen verstanden, die Zerewitinoff-aktiven Wasserstoff aufweisen. Beispiele für Verbindungen mit Zerewitinoff-aktivem Wasserstoff sind Verbindungen, die Carboxyl-, Hydroxyl-, Amino-, Imino- oder Thiol-Gruppen als funktionelle Gruppen enthalten.

Vorzugsweise stehen R₁ und R₂ daher für gleiche oder unterschiedliche organische Reste, die keine OH-, NH- oder SH-Gruppe aufweisen.

Im Rahmen einer Ausführungsform der vorliegenden Erfindung stehen R₁ und R₂ jeweils unabhängig voneinander für eine lineare oder verzweigte Alkyl-Gruppe mit 1 bis 10 Kohlenstoffatomen, besonders bevorzugt für eine Methyl- oder Ethylgruppe.

Im Rahmen einer bevorzugten Ausführungsform der vorliegenden Erfindung stehen R₁ und R₂ für eine Ethylgruppe, wobei X auf 2-Methyl-1.5-Diaminopentan als n-wertigem Amin basiert.

Bevorzugt steht n in Formel (I) für die Beschreibung der Wertigkeit des n-wertigen Amins für eine ganze Zahl von ≥ 2 bis ≤ 6, besonders bevorzugt ≥ 2 bis ≤ 4, beispielsweise 2.

Die Herstellung der aminofunktionellen Asparaginsäureester B) aus den genannten Ausgangsmaterialien kann nach DE 69311633 A erfolgen. Vorzugsweise erfolgt die Herstellung der aminofunktionellen Asparaginsäureester B) innerhalb eines Temperaturbereichs von ≥ 0 °C bis ≤ 100 °C. Vorzugsweise werden die Ausgangsmaterialien dabei in solchen Mengenverhältnissen eingesetzt, dass auf jede primäre Aminogruppe mindestens eine, vorzugsweise genau eine olefinische Doppelbindung entfällt. Im Anschluss an die Umsetzung können gegebenenfalls im Überschuss eingesetzte Ausgangsmaterialien destillativ abgetrennt werden. Die Umsetzung kann in Substanz oder in Gegenwart geeigneter Lösungsmittel wie Methanol, Ethanol, Propanol oder Dioxan oder Gemischen derartiger Lösungsmittel erfolgen. Auch Katalysatoren können zur Herstellung von B) eingesetzt werden.

Statt der aminofunktionellen Asparaginsäureester oder zusätzlich dazu können auch noch andere Verbindungen mit mindestens zwei isocyanatreaktiven Aminogruppen eingesetzt werden. Beispiele sind aliphatische, cycloaliphatische und/oder aromatische Di- beziehungsweise Polyamine, beispielsweise 1,2-Ethylendiamin, 1,2-Diaminopropan, 1,3-Diaminopropan, 1,4-Diaminobutan, 1,6-Diaminohexan, Isophorondiamin, Isomerengemisch von 2,2,4- und 2,4,4-Trimethylhexamethylendiamin, 2-Methylpentamethylendiamin, Diethylentriamin, Triaminononan, 1,3- und 1 ,4-Xylylendiamin, α,α,α',α'-Tetramethyl-1,3-xylylendiamin, α,α,α',α'-Tetramethyl-1,4-xylylendiamin, 4,4-Diaminodicyclohexylmethan, Dimethylethylendiamin, 1-Methyl-3,5-diethyl-2,4-diaminobenzol, 1-Methyl-3,5-diethyl-2,6-diaminobenzol, 1,3,5-Triethyl-2,6-diaminobenzol, 3,5,3',5'- Tetraethyl-4,4-diamino-diphenylmethan, 3,5,3',5'-Tetraisopropyl-4,4'-diaminodiphenylmethan, 3,5-Diethyl-3'5'-diisopropyl-4,4'-diamino-diphenylmethan, Polyoxyalkylenamine (Polyetheramine), wie Polypropylendiamin, oder beliebige Gemische derartiger Diamine beziehungsweise beliebige Gemische mit aminofunktionellen Asparaginsäureestern. Bevorzugt werden dabei Verbindungen mit reduzierter Reaktivität gegenüber Isocyanaten eingesetzt, beispielsweise di-primäre aromatische Diamine, die bevorzugt zusätzlich zu den Aminogruppen mindestens ein Alkylgruppe aufweisen. Beispiele hierfür sind 3,5-Diethyltoluyl-2,6-diamin oder 3,5-Diethyltoluyl-2,4-diamin oder Mischungen davon.

Die erfindungsgemäße Reaktionsmischung für das Polymerelement kann durch Mischen der Komponenten A) und B) erhalten werden. Das Verhältnis von Aminogruppen zu freien NCO-Gruppen ist dabei vorzugsweise ≥ 1:1,5 bis ≤ 0,8:1, besonders bevorzugt 1:1.

Die Geschwindigkeit bei 23 °C, bis eine weitgehende Vernetzung und Aushärtung der Mischung aus A) und B) erreicht ist, kann typischerweise ≥ 1 s bis ≤ 10 min, bevorzugt ≥ 1 min bis ≤ 8 min, besonders bevorzugt ≥1 min bis ≤ 5 min, betragen. Durch Katalysatoren kann die Aushärtung beschleunigt werden. Die Isocyanatgruppen des Polyisocyanates beziehungsweise des Polyisocyanat-Prepolymers der Komponente A) können neben der Komponente B), beispielsweise einem aminofunktionellen Asparaginsäureester, einem Diamin und/oder einem NH₂- und/oder NHfunktionellen Polyamin, auch teilweise mit anderen Verbindungen mit isocyanatreaktiven Gruppen, beispielsweise Diolen beziehungsweise Polyolen, umgesetzt werden. In einer bevorzugten Ausführungsform sind ≥ 50 Molprozent der isocyanatreaktiven Gruppen zur Aushärtung der Komponente A) aminofunktionelle Asparaginsäureester. Im Rahmen einer besonders bevorzugten Ausführungsform der vorliegenden Erfindung wird Komponente A) ausschließlich mit aminofunktionellen Asparaginsäureestern gehärtet.

Die Reaktionsmischung, umfassend die Komponenten A) und B) kann einerseits direkt auf den Elektroden aufgetragen und dort aushärten. Andererseits kann auch zunächst ein Film oder eine Folie aus der Reaktionsmischung hergestellt, und gegebenenfalls vollständig ausgehärtet, und anschließend mit den Elektroden kombiniert werden. Dabei können Klebstoffe zum Einsatz kommen oder es kann die Klebefähigkeit der Reaktionsmischung selbst ausgenutzt werden.

Die Reaktionsmischung kann neben den Komponenten A) und B) zusätzlich auch Hilfs- und Zusatzstoffe enthalten. Beispiele für solche Hilfs- und Zusatzstoffe sind Vernetzer, Verdicker, Colösemittel, Thixotropiermittel, Stabilisatoren, Antioxidantien, Lichtschutzmittel, Emulgatoren, Tenside, Klebstoffe, Weichmacher, Hydrophobierungsmittel, Pigmente, Füllstoffe und Verlaufshilfsmittel.

Die Reaktionsmischung kann neben den Komponenten A) und B) zusätzlich auch Füllstoffe enthalten. Diese Füllstoffe können beispielsweise die Dielektrizitätskonstante des Polymerelements regulieren. Vorzugsweise umfasst die Reaktionsmischung Füllstoffe zur Erhöhung der Dielektrizitätskonstanten wie Füllstoffe mit einer hohen Dielektrizitätskonstanten. Beispiele hierfür sind Ruß, Graphit, einwandige oder mehrwandige Kohlenstoff-Nanoröhrchen oder Mischungen davon. In diesem Zusammenhang sind insbesondere solche Rußtypen von Interesse, die eine Oberflächenpassivierung aufweisen und deshalb bei niedrigen Konzentrationen unterhalb der Perkolationsschwelle zwar die Dielektrizitätskonstante erhöhen und trotzdem nicht zu einer Erhöhung der Leitfähigkeit des Polymers führen.

Im Rahmen der vorliegenden Erfmdung können Additive zur Erhöhung der Dielektrizitätskonstanten und/oder der elektrischen Durchschlagsfeldstärke auch nach der Verfilmung noch zugesetzt werden. Dies kann beispielsweise durch Erzeugung einer (oder mehrerer) weiterer Schicht(en) oder durch Durchdringung des Polymerelements beispielsweise durch Eindiffusion in das Polymerelement erfolgen.

Der Auftrag der erfindungsgemäßen filmbildenden Zusammensetzungen kann nach allen an sich bekannten Applikationsformen erfolgen, genannt seien beispielsweise Rakeln, Streichen, Gießen, Schleudern, Sprühen oder Extrusion.

Darüber hinaus ist auch ein mehrschichtiger Auftrag mit gegebenenfalls zwischengelagerten Trocknungsschritten möglich.

Das Trocknen und Fixieren der Reaktionsmischung kann bei Temperaturen von ≥ 30 °C, vorzugsweise von ≥ 10 °C bis ≤ 200 °C, erfolgen. Dabei kann ein beschichtetes Substrat über eine geheizte Oberfläche, beispielsweise eine Walze, geführt werden. Der Auftrag sowie die Trocknung können jeweils diskontinuierlich oder kontinuierlich durchgeführt werden. Vorzugsweise ist das Verfahren gänzlich kontinuierliche.

Das erfindungsgemäße Polymerelement kann mit weiteren Schichten versehen werden. Dies kann einseitig oder beidseitig geschehen, in einer Schicht oder in mehreren Schichten übereinander, durch vollständige oder durch flächig partielle Beschichtung des Polymerelements.

Als Trägermaterialien für die Herstellung eines Polymerfilms eignen sich insbesondere Glas, Trennpapier, Folien und Kunststoffe, von denen der Polymerfilm gegebenenfalls einfach entfernt werden kann.

Die Verarbeitung der einzelnen Schichten kann durch Gießen oder händisch beziehungsweise maschinell durchgeführtes Rakeln erfolgen. Drucken, Siebdrucken, Spritzen, Sprühen und Tauchen sind ebenso mögliche Verarbeitungstechniken.

Das erfindungsgemäße Polymerelement weist vorteilhafterweise eine gute mechanische Festigkeit und hohe Elastizität auf. Insbesondere kann das erfindungsgemäße Polymerelement eine maximale Spannung von ≥ 0,2 MPa, insbesondere von ≥ 0,4 MPa und ≤ 50 MPa, und eine maximale Dehnung von ≥ 250 %, insbesondere von ≥ 350 %, aufweisen. Darüber hinaus kann das erfindungsgemäße Polymerelement im Gebrauchsdehnungsbereich von ≥ 100 % bis ≤ 200 %eine Spannung von ≥ 0,1 MPa bis ≤ 1 MPa, beispielsweise von ≥ 0,1 MPa bis ≤ 0,8MPa, insbesondere von ≥ 0,1 MPa bis ≤ 0,3 MPa, aufweisen (Bestimmung nach DIN 53504). Ferner kann das erfindungsgemäße Polymerelement ein Elastizitätzmodul bei einer Dehnung von 100 % von ≥ 0,1 MPa bis ≤ 10 MPa, beispielsweise von ≥ 0,2 MPa bis ≤ 5 MPa, aufweisen (Bestimmung nach DIN EN 150 672 1-1).

Nach dem Vernetzen kann ein als Polymerfilm, Polymerfolie oder Polymerbeschichtung ausgebildetes erfindungsgemäßes Polymerelement eine Schichtdicke von ≥ 0,1 µm bis ≤ 1500 µm, beispielsweise von ≥ 1 µm bis ≤ 500 µm, insbesondere von ≥ 5 µm bis ≤ 200 µm, vorzugsweise von ≥ 5 µm bis ≤ 50 µm, aufweisen.

Die Filme haben weiterhin vorteilhafterweise gute elektrische Eigenschaften; diese werden für die Durchbruchsfeldstärke nach ASTM D 149 und für die Messungen der Dielektrizitätskonstante ASTM D 150 bestimmt.

Zum Aufbau eines erfindungsgemäßen Wandlers können die erfindungsgemäßen Polymerelemente beidseitig mit Elektroden, wie beispielsweise in WO 01/06575 beschrieben, beschichtet werden. Dieser grundsätzliche Aufbau kann in unterschiedlichsten Konfigurationen zur Herstellung von Sensoren, Aktuatoren und/oder Generatoren eingesetzt werden.

### Beispiele:

Sofern nicht abweichend gekennzeichnet, beziehen sich alle Prozentangaben auf das Gewicht.

Sofern nicht abweichend vermerkt, beziehen alle analytischen Messungen auf Temperaturen von 23°C.

NCO-Gehalte wurden, wenn nicht ausdrücklich anders erwähnt, volumetrisch gemäß DIN-EN ISO 11909 bestimmt.

Die angegebenen Viskositäten wurden mittels Rotationsviskosimetrie nach DIN 53019 bei 23 °C mit einem Rotationsviskosimeter der Firma Anton Paar Germany GmbH, Ostfildern, Deutschland bestimmt.

Die Einarbeitung von Füllstoffen in die erfindungsgemäßen Dispersionen geschah mit einem Speedmixer (Modell 150 FV der Firma Hauschild & Co KG, Postfach 43 80, Deutschland, 59039 Hamm).

Messungen der Filmschichtdicken wurden mit einem mechanischen Taster der Firma Heidenhain GmbH, Deutschland, Postfach 1260, 83292 Traunreut, durchgeführt. Die Probekörper wurden an drei unterschiedlichen Stellen vermessen und der Mittelwert als repräsentativer Messwert benutzt.

Die Zugversuche wurden mittels einer Zugmaschine der Firma Zwick, Modell Nummer 1455, ausgestattet mit einer Kraftmessdose des Gesamtmessbereiches 1kN nach DIN 53 504 mit einer Zuggeschwindigkeit von 50 mm/min ausgeführt. Als Probekörper wurden S2-Zugstäbe eingesetzt. Jede Messung wurde an drei gleichartig präparierten Probekörpern ausgeführt und der Mittelwert der erhaltenen Daten zur Bewertung verwendet. Speziell hierfür wurden neben der Zugfestigkeit in [MPa] und der Bruchdehnung in [%] noch die Spannung in [MPa] bei 100% und 200% Dehnung bestimmt.

Die Bestimmung des elektrischen Volumen-Widerstandes wurde mit einem Messaufbau der Firma Keithley Instruments Inc., 28775 Aurora Road, Cleveland, Ohio 44139, Vereinigten Staaten von Amerika (Elektrometer: Modell-Nummer 6517A; Messkopf : Modell-Nummer 8009) und einem mitgelieferten Programm (Modell-Nummer 6524: High Resistance Measurement Software) durchgeführt. Es wurde eine symmetrische, rechteckörmige Spannung von +/- 50 V für die Dauer von 4 min pro Periode für die Dauer von 10 Perioden angelegt und der Stromfluss bestimmt. Aus den Werten für den Stromfluss kurz vor Umschalten der Spannung wurde der Widerstand des Prüfkörpers bei jeder Periode der Spannung berechnet und gegen die Periodenanzahl aufgetragen.

Der Endwert dieser Auftragung gibt den Messwert für den elektrischen Volumen-Widerstand der Probe an.

Messungen der Dielektrizitätskonstante gemäß ASTM D 150-98 wurden mit einem Messaufbau der Firma Novocontrol Technologies GmbH & Co. KG, Obererbacher Straße 9,

56414 Hundsangen, Deutschland (Messbrücke : Alpha-A Analyzer, Messkopf: ZGS Active Sample Cell Test Interface) mit einem Durchmesser der Probekörper von 20 mm ausgeführt. Untersucht wurde dabei ein Frequenzbereich von 10⁷ Hz bis 10⁻² Hz. Als Maß für die Dielektrizitätskonstante des untersuchten Materials wurde der Realteil der Dielektrizitätskonstante bei 10⁻² Hz gewählt.

Die Bestimmung der Durchbruchsfeldstärke gemäß ASTM D 149-97a wurde mit einer Hochspannungsquelle Modell LNC 20000-3pos der Firma Heinzinger, Anton-Jakob-Str. 4 in 83026 Rosenheim, Deutschland, und einem eigenkonstruierten Probenhalter am DKI (Deutsches Kunststoffinstitut, Schloßgartenstr. 6 in 64289 Darmstadt, Deutschland) durchgeführt. Der Probenhalter kontaktiert die homogen dicken Polymerproben mit nur geringer mechanische Vorbelastung und verhindert, dass der Bediener in Kontakt mit der Spannung kommt. Die nicht vorgespannte Polymerfolie wird in diesem Aufbau - zur Isolation gegen Durchschläge in der Luft in Siliconöl - mit steigender Spannung statisch belastet, bis ein elektrischer Durchbruch durch die Folie erfolgt. Messergebnis ist die beim Durchbruch erreichte Spannung, bezogen auf die Dicke der Polymerfolie in [V/µm].

### Verwendete Substanzen und Abkürzungen:

- Printex 140: Produkt der Degussa GmbH, Weißfrauenstr. 9, 60311 Frankfurt am Main, Deutschland,
Mittlere Korngröße 29 nm, BET-Oberfläche 90 m²/g, pH-Wert 4,5 (alle Angaben hierzu laut Datenblatt Degussa)
- Härter DT: Substituiertes aromatisches Diamin, NH-Equivalentzahl ca. 90, Aminzahl ca. 630 mg KOH/g, Viskosität ca. 200 mPas

### Anwendungstechnische Versuche

### Beispiel 1 (Prepolymer A-1):

840 g Hexamethylendiisocyanat (HDI) und 0,08 g Zinkoctoat wurden in einem 4 Liter Vierhalskolben vorgelegt. Innerhalb von einer Stunde wurden bei 80 °C 1000 g eines difunktionellen Polypropylenglykol-Polyethers mit einer Molmasse von 8000 g/mol hinzugefügt und eine Stunde nachgerührt. Dann wurden 0,3 g Benzoylchlorid zugefügt. Anschließend wurde durch Dünnschichtdestillation bei 130 °C und 0,1 Torr das überschüssige HDI abdestilliert. Man erhielt ein Prepolymer mit einem NCO-Gehalt von 1,80 %.

### Beispiel 2 (Prepolymer A-2):

840 g Toluylendiisocyanat (TDI) und 0,08 g Zinkoctoat wurden in einem 4 Liter Vierhalskolben vorgelegt. Innerhalb von einer Stunde wurden bei 80 °C 1000 g eines difunktionellen Polypropylenglykol-Polyethers mit einer Molmasse von 8000 g/mol hinzugefügt und eine Stunde nachgerührt. Dann wurden 0,3 g Benzoylchlorid zugefügt. Anschließend wurde durch Dünnschichtdestillation bei 130 °C und 0,1 Torr das überschüssige TDI abdestilliert. Man erhielt ein Prepolymer mit einem NCO-Gehalt von 1,66 %.

### Beispiel 3 (Aspartat B)

Zu 2 Mol Diethylmaleat wurde unter Stickstoffatmosphäre langsam derart 1 Mol 2-Methyl-1.5-Diaminopentan zugetropft, dass die Reaktionstemperatur 60 °C nicht überschritt. Anschließend wurde so lange auf 60 °C erwärmt, bis kein Diethylmaleat mehr im Reaktionsgemisch nachweisbar war.

### Beispiel 4 (erfindungsgemäß)

Die eingesetzten Rohstoffe wurden nicht separat entgast. Die benötigten Mengen von 2 g an Aspartat B aus Beispiel 3 und 20,79 g Prepolymer A-2 aus Beispiel 2 wurden in einen Polypropylen-Becher eingewogen und im Speedmixer bei 3000 Umdrehungen pro Minute für 2 s vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Beispiel 5 (erfindungsgemäß)

Die eingesetzten Rohstoffe wurden nicht separat entgast. Die benötigten Mengen von 2 g an Härter DT und 71,99 g Prepolymer A-2 aus Beispiel 2 wurden in einen Polypropylen-Becher eingewogen und im Speedmixer bei 3000 Umdrehungen pro Minute für 2 s vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Beispiel 6 (erfindungsgemäß)

Die eingesetzten Rohstoffe wurden nicht separat entgast. Die benötigten Mengen von 0,5 g an Härter DT, 0,5 g Aspartat B aus Beispiel 3 und 18,07 g Prepolymer A-1 aus Beispiel 1 wurden in einen Polypropylen-Becher eingewogen und im Speedmixer bei 3000 Umdrehungen pro Minute für 2 s vermischt. Aus dem noch flüssigen Reaktionsgemisch wurden auf Glasplatten von Hand Filme einer Nassschichtdicke von 1 mm gerakelt. Alle Filme wurden nach der Herstellung bei 100 °C im Trockenschrank über Nacht getrocknet und anschließend 5 min bei 120 °C nachgetempert. Die Filme konnten nach dem Tempern von Hand einfach von der Glasplatte gelöst werden.

### Beispiel 7 (Vergleichsbeispiel)

Alle flüssigen Rohstoffe wurden in einem dreistufigen Verfahren sorgfältig unter Argon entgast, der Ruß wurde über ein 125 µm Sieb gesiebt. 10 g Terathane 650 (INVISTA GmbH, D-65795 Hatterheim, Poly-THF der Molmasse Mn = 650) wurden mit 0,596 g Ruß (Ketjenblack EC 300 J, Produkt der Akzo Nobel AG) in einem 60 ml Einweg-Mischbehälter (APM-Technika AG, Best, Nr. 1033152) eingewogen und im Speedmixer (Produkt der Firma APM-Technika AG, 9435 Heerbrugg, Schweiz; Vertrieb D: Hauschild; Typ DAC 1 50 FVZ ) 3 min bei 3000 Umdehungen pro Minute zu einer homogenen Paste vermischt. Anschließend wurden 0,005 g Dibutylzinndilaurat (Metacure® T-12, Air Products and Chemicals, Inc.) und 6,06 g des Isocyanates N3300 (das Isocyanurattrimere des HDI; Produkt der Bayer MaterialScience AG) dazu gewogen und 1 min bei 3000 Umdrehungen pro Minute im Speedmixer vermischt. Die Reaktionspaste wurde auf eine Glasplatte gegossen und mit einem Rakel der Nassschichtdicke 1 mm zu einem homogenen Film des Feststoffgehaltes 2 % ausgezogen. Der Film wurde anschließend 16 h bei 80 °C getempert.

### Beispiel 8 (Vergleichsbeispiel)

Alle flüssigen Rohstoffe wurden in einem dreistufigen Verfahren sorgfältig unter Argon entgast. 10 g Terathane 650 (INVISTA GmbH, 65795 Hatterheim, Deutschland, Poly-THF der Molmasse Mn = 650) wurden in einem 60 ml Einweg-Mischbehälter (APM-Technika AG, Best, Nr. 1033152) eingewogen. Anschließend wurden 0,005 g Dibutylzinndilaurat (Metacure® L-12, Air Products and Chemicals, Inc.) und 6,06 g des Isocyanates N3300 (das Isocyanurattrimere des HDI; Produkt der Bayer MaterialScience AG) dazu gewogen und 1 min bei 3000 Umdrehungen pro Minute im Speedmixer vermischt. Das Reaktionprodukt wurde auf eine Glasplatte gegossen und mit einem Rakel der Nassschichtdicke 1 mm zu einem homogenen Film ausgezogen. Der Film wurde anschließend 16 h bei 80 °C getempert.

### Beispiel 9 (Vergleichsbeispiel)

Alle flüssigen Rohstoffe wurden in einem dreistufigen Verfahren sorgfältig unter Argon entgast, der Ruß wurde über ein 125 µm Sieb gesiebt. 10 g Terathane 650 (INVISTA GmbH, 65795 Hatterheim, Deutschland, Poly-THF der Molmasse Mn = 650) wurde mit 0,536 g Printex 140, in einem 60 ml Einweg-Mischbehälter (APM-Technika AG, Best. Nr. 1033 1 52) eingewogen und im Speedmixer (Produkt der Firma APM-Technika AG, 9435 Heerbrugg, Schweiz; Vertrieb D: Hauschild; Typ DAC 150 FVZ ) 3 min bei 3000 Umdrehungen pro Minute zu einer homogenen Paste vermischt. Anschließend wurden 0,005 g Dibutylzinndilaurat (Metacure® T-12, Air Products and Chemicals, Inc.) und 6,06 g des Isocyanates N3300 (das Isocyanurattrimere des HDI; Produkt der Bayer MaterialScience AG) dazu gewogen und 1 min bei 3000 Umdrehungen pro Minute im Speedmixer vermischt. Die Reaktionspaste wurde auf eine Glasplatte gegossen und mit einem Rakel der Nassschichtdicke 1 mm zu einem homogenen Film des Feststoffgehaltes 2 % ausgezogen. Der Film wurde anschließend 16 h bei 80 °C getempert.

**Tabelle 1: Eigenschaften der in den Beispielen 4 bis 9 hergestellten Filme**

| Beispiel | Bruchdehnung | Zugfestig keit | Spannung bei 100 % Dehnung | Spannung bei 200 % Dehnung | elektrischer Volumen-Widerstand | Dielektrizität skonstante | Durchbruchs feldstärke |
|---|---|---|---|---|---|---|---|
| | [%] | [MPa] | [MPa] | [MPa] | [Ohm cm] | | [V/µm]] |
| 4* | 288 | 1,1 | 0,47 | 0,48 | 1,9 · 10¹¹ | 25,0 | 25 |
| 5* | 253 | 3,8 | 1,60 | 3,00 | 2,6 · 10¹² | 9,0 | 29 |
| 6* | 316 | 2,1 | 0,87 | 1,36 | 1,9 · 10¹¹ | 36,6 | 32 |
| 7 | 57 | 3,4 | - | - | 6,4 · 10¹¹ | 28,4 | 7 |
| 8 | 44 | 1,7 | - | - | 2,7 · 10¹² | 18,6 | 11 |
| 9 | 46 | 1,6 | - | - | 7,9 · 10¹¹ | 550,0 | 5 |

| | | | | | | | |
|---|---|---|---|---|---|---|---|
| * erfindungsgemäß | | | | | | | |

Es zeigte sich bei den Versuchen, dass die erfindungsgemäßen Filme deutliche Vorteile gegenüber dem Stand der Technik bieten. Insbesondere für die erfindungsgemäßen Filme aus Asparaginsäureestern und Polyisocyant-Prepolmeren konnten diese Vorteile noch gesteigert werden.

Besonders vorteilhaft bei Einsatz der erfindungsgemäßen Filme sind die hohe Dielektrizitätskonstante bei gleichzeitig sehr hoher Durchbruchsfeldstärke in ungedehntem Zustand, insbesondere bei den besonders bevorzugten Ausführungsformen der erfindungsgemäßen Filme aus Asparaginsäureestern und Polyisocyanat-Prepolmeren, und die sehr guten mechanischen Eigenschaften wie hohe Elastizität, hohe Reißdehnung, gut geeigneter Spannungs-Dehnungs-Verlauf mit niedriger Spannung bei moderaten Dehnungen im Gebrauchsbereich der Anwendung. Insbesondere die Bruchdehnung und das Dehnungsverhalten konnten zusätzlich zur hohen Dielektrizitätskonstante bei gleichzeitig sehr hoher Durchbruchsfeldstärke in ungedehntem Zustand bei den besonders bevorzugten Ausführungsformen der erfindungsgemäßen Filme aus Asparaginsäureestern und Polyisocyanat-Prepolmeren noch gesteigert werden. Bei den Vergleichsbeispielen war eine Spannung bei 100 % beziehungsweise 200 % nicht messbar, da diese Materialien bereits bei 40 % bis 60 % rissen.

## Patentansprüche

1. Elektromechanischer Wandler aufweisend mindestens zwei Elektroden und mindestens ein Polymerelement, wobei das Polymerelement zwischen zwei Elektroden angeordnet ist,
**dadurch gekennzeichnet dass**
das Polymerelement aus einer Reaktionsmischung umfassend die folgenden Komponenten
A) ein Polyisocyanat oder ein Polyisocyanat-Prepolymer oder eine Mischung davon, und
B) eine Verbindung mit mindestens zwei isocyanatreaktiven Aminogruppen,
erhältlich ist.

2. Wandler nach Anspruch 1, **dadurch gekennzeichnet, dass** der elektromechanische Wandler ein Sensor und/oder Aktuator und/oder Generator ist.

3. Wandler nach Anspruch 1 oder 2, **dadurch gekennzeichnet, dass** Komponente
A) ein Isocyanuratgruppen- und/oder Urethangruppen-haltiges Polyisocyanat oder ein Isocyanuratgruppen- und/oder Urethangruppen-haltiges Polyisocyanat-Prepolymer oder eine Mischung davon
ist.

4. Wandler nach einem der Ansprüche 1 bis 3, **dadurch gekennzeichnet, dass** Komponente
B) ein aminofunktioneller Asparaginsäureester
ist.

5. Wandler nach einem der Ansprüche 1 bis 4, **dadurch gekennzeichnet, dass** Komponente
B) ein aminofunktioneller Asparaginsäureester der allgemeinen Formel (I): 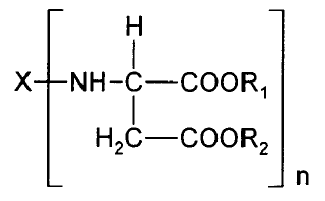 ist, wobei
X für einen n-wertigen organischen Rest steht, der durch Entfernung von mindestens zwei primären Aminogruppen eines n-wertigen Amins erhalten wird,
R₁, R₂ für gleiche oder unterschiedliche organische Reste stehen, die keinen Zerewitinoff-aktiven Wasserstoff aufweisen, und
n für eine ganze Zahl ≥ 2 steht.

6. Wandler nach einem der Ansprüche 1 bis 5, **dadurch gekennzeichnet, dass** Komponente
B) ein aminofunktioneller Asparaginsäureester der allgemeinen Formel (I): 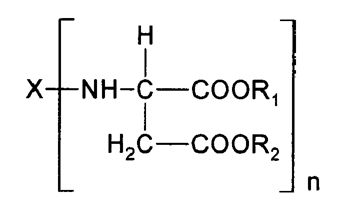 ist, wobei
X für einen zwei-wertigen organischen Rest steht, der durch Entfernung der Aminogruppen von 1,4-Diaminobutan, 1,6-Diaminohexan, 2-Methyl-1.5-Diaminopentan, 2,2,4- oder 2,4,4-Trimethyl-1,6-diaminohexan erhalten wird,
R₁, R₂ jeweils unabhängig voneinander für eine lineare oder verzweigte Alkyl-Gruppe mit 1 bis 10 Kohlenstoffatomen stehen, und
n für 2 steht.

7. Verfahren zur Herstellung eines elektromechanischen Wandlers nach einem der Ansprüche 1 bis 6, in dem
- mindestens zwei Elektroden bereitgestellt werden, und
- ein Polymerelement durch Umsetzung einer Reaktionsmischung umfassend die folgenden Komponenten
A) ein Polyisocyanat oder ein Polyisocyanat-Prepolymer oder eine Mischung davon, und
B) eine Verbindung mit mindestens zwei isocyanatreaktiven Aminogruppen,
bereitgestellt wird, und
- das Polymerelement zwischen zwei Elektroden angeordnet wird.

8. Verfahren nach Anspruch 7, **dadurch gekennzeichnet, dass** das Polymerelement durch Auftragen der Reaktionsmischung auf mindestens eine der Elektroden bereitgestellt wird.

9. Verfahren nach Anspruch 7 oder 8, **dadurch gekennzeichnet, dass** die Reaktionsmischung getrocknet und/oder getempert wird.

10. Verwendung eines Polymerelements, erhältlich aus einer Reaktionsmischung umfassend die folgenden Komponenten
A) ein Polyisocyanat oder ein Polyisocyanat-Prepolymer oder eine Mischung davon, und
B) eine Verbindung mit mindestens zwei isocyanatreaktiven Aminogruppen,
als elektromechanisches Element.

11. Elektronische und/oder elektrische Vorrichtung umfassend einen elektromechanischen Wandler nach einem der Ansprüche 1 bis 6.

12. Verwendung eines elektromechanischen Wandlers nach einem der Ansprüche 1 bis 6 in einer elektronischen und/oder elektrischen Vorrichtung.
